# EUROPEAN PATENT APPLICATION

(11) **EP 4 625 488 A1**
(43) Date of publication of application: **01.10.2025**
(21) Application number: 25166575.8
(22) Date of filing: 27.03.2025
(51) Int. Cl.: H01L 23/373, H01L 23/42

(54) **ONE-PART DISPENSABLES AND METHODS FOR REDUCING THE SPREADING OF MATERIAL(S) MIGRATING FROM ONE-PART DISPENSABLES AND/OR FOR IMPROVING VERTICAL STABILITY OF ONE-PART DISPENSABLES**

(30) Priority: 28.03.2024 US 202463570998 P; 09.05.2024 US 202463644824 P
(71) Applicant: Laird Technologies, Inc., Chesterfield, MO 63017 (US)
(72) Inventor: Li, Yuqin, Chesterfield, Missouri, 63017 (US)
(74) Representative: Greif, Thomas

(57) **Abstract**

Disclosed are exemplary one-part dispensables (broadly, composites) configured to be usable with reduced spreading of material(s), if any, migrating therefrom *(e.g.,* reduced oil bleed spreading, *etc.)* and good vertical stability *(e.g.,* vertically stable during thermal cycling and/or vibration, *etc.).* Also disclosed are exemplary methods for reducing the spreading of material(s), if any, migrating *(e.g.,* reducing oil bleeding, *etc.)* from one-part dispensables and/or for improving or providing good vertical stability of the one-part dispensables. The one-part dispensables may comprise thermal management and/or electromagnetic interference (EMI) mitigation materials (*e.g.*, thermal interface materials (TIMs), EMI absorbers, thermally-conductive EMI absorbers, electrically-conductive elastomers (ECEs), electrically-conductive composites, combinations thereof, *etc.)* or other polymer-inorganic composite materials used for other purposes.

## Description

### FIELD

The present disclosure relates to one-part dispensables (broadly, composites) configured to be usable with reduced spreading of material(s), if any, migrating therefrom (*e.g*., reduced oil bleed spreading, *etc.)* and good vertical stability *(e.g.,* vertically stable during thermal cycling and/or vibration, *etc.).* The present disclosure also relates to methods for reducing the spreading of material(s), if any, migrating *(e.g.,* reducing oil bleeding, *etc.)* from one-part dispensables and/or for improving vertical stability of the one-part dispensables.

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

In addition, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

A common solution to ameliorate the effects of EMI/RFI is through the use of shields capable of absorbing and/or reflecting and/or redirecting EMI energy. These shields are typically employed to localize EMI/RFI within its source, and to insulate other devices proximal to the EMI/RFI source. These shields may be composed of metal, polymer-inorganic composites, filled foams, foam materials wrapped or coated with absorbing and/or reflecting materials, and the like.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

The above mitigation/management materials, if not comprised of metal, often consist of inorganic-polymer composites or metal-polymer composites. The concentration of the inorganic material, which is usually a particle, in the polymer matrices is often high, for the purpose of attaining the desired management of thermal and/or EMI issues.

In some instances, the composites are used in applications where they are compressed between two portions of the device requiring management of thermal and/or EMI issues. This compression may occur during the assembly of a device or during cycles of compression and expansion during use of a device. As a result, the composites must be 'soft' so they can readily deflect and absorb the forces of compression, without transferring those forces to the device being protected with the associated risk of physical damage. As is known to those skilled in the art, in some situations the methods used to prepare such soft composites lead to materials from which various organic species may migrate over time, particularly after repeated cycles of compression and expansion. These organic species may consist of polymers, monomers, additives used to form the composite or to enhance its performance during use, complexes of organic materials with inorganic materials, and the like. The term 'oil bleed' is commonly used within the industry to describe this phenomenon, and will be used in this document with the understanding that 'oil' refers to a range of primarily organic species and 'bleed' refers to the movement of materials from within the composites to a location, or locations, external to the composites.

### DRAWINGS

The drawings described herein are for illustrative purposes only of selected embodiments and not all possible implementations, and is not intended to limit the scope of the present disclosure.

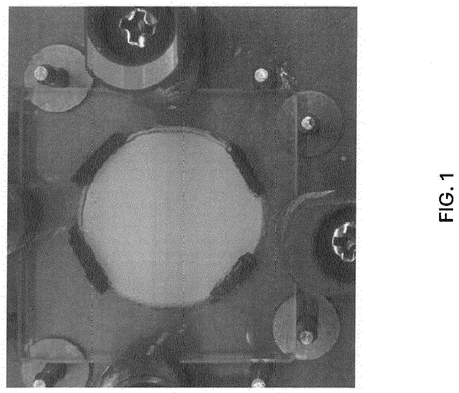

FIG. 1 shows a one-part dispensable including an exterior portion (*e.g*., outermost perimeter sidewall portion, *etc.)* that is cured, oxidized, and/or otherwise hardened according to an exemplary embodiment after a vertical reliability test in thermal shock -40 degrees Celsius (°C) to 125 °C. The cured, oxidized, and/or hardened exterior portion of the one-part dispensable provides good adhesion with the substrate such that the one-part dispensable did not slide along the substrate during vertical reliability test.

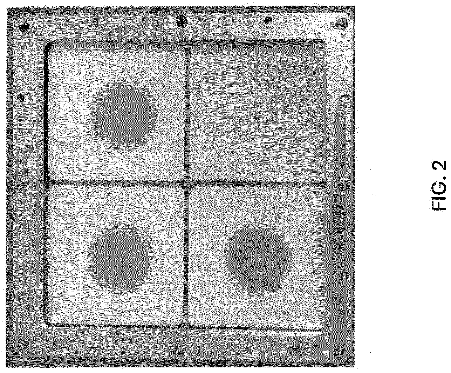

FIG. 2 shows three one-part dispensables (inner circular portions in FIG. 2) each including an exterior portion (*e.g*., outermost perimeter sidewall portions, *etc.)* that is cured, oxidized, and/or otherwise hardened according to an exemplary embodiment after bleed testing at 125 °C for three days. The cured, oxidized, and/or hardened exterior portion of the one-part dispensable is operable for reducing spreading of material(s) migrating (*e.g.,* oil bleeding forming the outer ring in FIG. 2, *etc.)* from the one-part dispensable. Accordingly, the exterior portion of the one-part dispensable that is cured, oxidized, and/or otherwise hardened enables the one-part dispensable to have a low level of bleeding.

### DETAILED DESCRIPTION

Example embodiments will now be described more fully with reference to the accompanying drawings.

Consumer electronics often have oil bleed (broadly, migration of materials) from thermal interface composite materials. And this oil bleed is a concern as it can sometimes interfere with workings of electronic packages or devices and/or cause aesthetic issues. There is also a concern on how one-part dispensable material can remain in place (*e.g.,* without sliding, *etc.)* during various thermal cycling and/or in a vibration environment. One conventional solution is to use two-part dispensables. But there are other issues with two-part dispensables, for example, significantly reduced flow due to the static mixer and double amount of equipment needed to dispense the two parts.

Disclosed herein are exemplary one-part dispensables that are configured to be usable with reduced spreading of material(s), if any, migrating therefrom *(e.g.,* reduced oil bleed spreading, *etc.)* and good vertical stability (*e.g*., vertically stable during thermal cycling and/or vibration, *etc.).* Also disclosed are methods for reducing the spreading of material(s), if any, migrating (*e.g*., reducing oil bleeding, *etc.)* from one-part dispensables (broadly, composites) and/or for improving or providing good vertical stability of the one-part dispensables. The one-part dispensables may comprise thermal management and/or electromagnetic interference (EMI) mitigation materials (*e.g.,* thermal interface materials (TIMs), EMI absorbers, thermally-conductive EMI absorbers, electrically-conductive elastomers (ECEs), electrically-conductive composites, combinations thereof, *etc.)* or other polymer-inorganic composite materials used for other purposes.

Advantageously, the exemplary one-part dispensables disclosed herein can be applied with standard dispensing equipment. After the one-part dispensable material is dispensed, no or minimal additional process is needed to cure, oxidize, and/or otherwise harden the exterior portion (*e.g*., outer ring, outermost perimeter sidewall portion, *etc.)* of the one-part dispensable in the assembly. For example, the exterior portion of the one-part dispensable may be cured, oxidized, and/or otherwise hardened solely by exposure to oxygen in the atmosphere, *e.g.,* after the one-part dispensable is between *(e.g.,* sandwiched, and/or compressed between, *etc.)* first and second opposing surfaces within an electronic device, *etc.*

In exemplary embodiments, a one-part dispensable (broadly, a composite) includes an exterior portion *(e.g.,* outermost perimeter sidewall portion, *etc.)* that is cured, oxidized, and/or otherwise hardened such that the exterior portion is operable for preventing or inhibiting further spreading of material(s), if any, migrating *(e.g.,* oil bleeding, *etc.)* from the one-part dispensable. Accordingly, the exterior portion of the one-part dispensable that is cured, oxidized, and/or otherwise hardened enables the one-part dispensable to have a low level of bleeding.

In exemplary embodiments, a one-part dispensable (broadly, a composite) includes an exterior portion (e.g., outermost perimeter sidewall portion, *etc*.) that is cured, oxidized, and/or otherwise hardened the exterior portion *(e.g.,* outermost perimeter sidewall portion, *etc.)* such that the exterior portion provides good adhesion with a surface *(e.g.,* a surface defined by a substrate, electronic component, heat source, *etc.).* The good adhesion provided between the exterior portion of the one-part dispensable and the surface prevents or inhibits sliding of the one-part dispensable along the surface, such as during thermal cycling and/or vibration, *etc.* The cured, oxidized, and/or hardened exterior portion of the one-part dispensable may provide good adhesion with the surface that is better or stronger than the adhesion between the substrate and the interior portion of the one-part dispensable (*e.g*., a naturally or inherently tacky material, *etc.)* that is not cured, oxidized, and/or otherwise hardened.

In exemplary embodiments, the exterior portion of the one-part dispensable may comprise a cured, oxidized, and/or otherwise hardened ring or dam (broadly, a portion) of the one-part dispensable that is disposed or extends along an outermost perimeter edge or sidewall of the one-part dispensable.

In exemplary embodiments, the exterior portion of the one-part dispensable may be cured by exposure to oxygen and/or by the application of heat (*e.g*., pre-heating of the one-part dispensable before dispensing, *etc.).* Or, for example, the exterior perimeter of the one-part dispensable may be cured, oxidized, and/or otherwise hardened solely by exposure to oxygen in the atmosphere.

The exterior portion of the one-part dispensable that is cured, oxidized, and/or otherwise hardened is an integral portion of the one-part dispensable such that the exterior portion has the same formulation (*e.g*., same matrix material and functional fillers, *etc.)* as the remainder of the one-part dispensable.

FIG. 1 shows a one-part dispensable according to an exemplary embodiment after a vertical reliability test in thermal shock -40 degrees Celsius (°C) to 125 °C. The one-part dispensable includes an exterior portion (*e.g*., outermost perimeter sidewall portion, *etc*.) that is cured, oxidized, and/or otherwise hardened. Generally, FIG. 1 shows that the cured, oxidized, and/or hardened exterior portion of the one-part dispensable provides good adhesion with the substrate such that the one-part dispensable did not slide along the substrate during vertical reliability test. The cured, oxidized, and/or hardened exterior portion of the one-part dispensable may provide good adhesion with the substrate that is better or stronger than the adhesion between the substrate and the interior portion of the one-part dispensable that is not cured, oxidized, and/or otherwise hardened.

FIG. 2 shows three one-part dispensables (inner circular portions in FIG. 2) according to exemplary embodiments after bleed testing at 125 °C for three days. Each one-part dispensable includes an exterior portion *(e.g.,* outermost perimeter sidewall portion, *etc*.) that is cured, oxidized, and/or otherwise hardened. Generally, FIG. 2 shows that the cured, oxidized, and/or hardened exterior portion of the one-part dispensable is operable for reducing spreading of material(s) migrating (e.g., oil bleeding forming the outer ring in FIG. 2, *etc.)* from the one-part dispensable. Accordingly, the exterior portion of the one-part dispensable that is cured, oxidized, and/or otherwise hardened enables the one-part dispensable to have a low level of bleeding.

Similar benefits of reducing oil bleed spreading are expected for other thermal interface materials (TIMs), thermal management and/or electromagnetic interference (EMI) mitigation materials, and other polymer-inorganic composite materials used for other purposes, which have the potential to bleed. Accordingly, this invention will have wide applicability to a wide range of thermal interface materials (TIMs), thermal management and/or electromagnetic interference (EMI) mitigation materials, and other polymer-inorganic composite materials used for other purposes, in which it would be desirable to have reduced spreading of material(s) migrating (*e.g.,* migration of organic species, oil bleed, *etc.)* from at composite to locations external to the composite. In addition, exemplary embodiments disclosed herein may be used in a wide range of industries (*e.g*., automotive, consumer, industrial, datacom/telecom, aerospace/defense, *etc*.) and wide range of applications (*e.g.,* automotive electronics, automotive advanced driver-assistance systems (ADAS), automotive powertrain/electronic control units (ECUs), automotive infotainment, industrial power, routers, wireless infrastructure, drones/satellites, gaming systems, smart home devices, notebooks/tablets/portable devices, *etc.).*

It is challenging to balance the preparation of a highly-loaded polymer composite for use as a thermal management and/or EMI mitigation material that has the ability to fulfill the desired thermal management and/or EMI mitigation requirements and other requirements while also readily deflecting under low levels of applied force. In these materials, oil bleeding may result for multiple reasons. For example, conventional thermal management and/or EMI mitigation materials are commonly based on the use of silicone polymers. Silicone polymers typically contain a wide distribution of molecular weight (MW) polymers. It is commonly assumed that some of the polymer with low molecular weights are capable of migration in the matrix to such an extent that the migrated polymer materials become visibly apparent beyond the confines of the composite, thereby resulting in undesirable aesthetics. Other additives in the composite in addition to the silicone polymers, such as dispersing agents, stabilizing agents (*e.g.,* UV stabilizers, thermal stabilizers, *etc.)* and the like, may also migrate. Composites that use polymers that are not based on silicone materials also contain species capable of migration, and face similar challenges as described above for representative silicone-based systems.

But as disclosed herein, the spreading of material(s) migrating *(e.g.,* reducing oil bleed spreading, *etc.)* from a one-part dispensable (broadly, a composite) may be reduced by an exterior portion of the composite that is cured, oxidized, and/or otherwise hardened. This is significant in that oil bleed is a concern for aesthetic reasons as well as due to the potential contamination of optics in electronic applications (*e.g*., optical transceivers, camera lenses, *etc.),* such as high speed signal lines that may otherwise be affected by oil bleed. Exemplary embodiments may advantageously stop or inhibit oil bleed spreading along a device casing or housing, which oil bleed might otherwise not be aesthetically pleasing.

Disclosed are exemplary one-part dispensables (broadly, composites) configured to be usable with reduced spreading of material(s), if any, migrating therefrom (*e.g*., reduced oil bleed spreading, *etc.)* and good vertical stability (*e.g*., vertically stable during thermal cycling and/or vibration, *etc.*). Also disclosed are exemplary methods for reducing the spreading of material(s), if any, migrating (e.g., reducing oil bleeding, *etc.)* from one-part dispensables and/or for improving or providing good vertical stability of the one-part dispensables. The one-part dispensables may comprise thermal management and/or electromagnetic interference (EMI) mitigation materials (*e.g*., thermal interface materials (TIMs), EMI absorbers, thermally-conductive EMI absorbers, electrically-conductive elastomers (ECEs), electrically-conductive composites, combinations thereof, *etc.)* or other polymer-inorganic composite materials used for other purposes.

In an exemplary method for reducing the spreading of material(s), if any, migrating from a composite, the method comprises positioning the composite between first and second opposing surfaces such that an exterior portion of the composite remains exposed for curing of the exterior portion of the composite. After curing of the exterior portion of the composite, the cured exterior portion of the composite is operable for reducing the spreading of material(s), if any, migrating from the composite along the first and/or second opposing surfaces and/or for providing good adhesion with the first and/or second opposing surfaces that inhibits sliding of the composite along the first and/or second opposing surfaces.

In an exemplary method for reducing the spreading of material(s), if any, migrating from a composite, the method comprises exposing an exterior portion of a composite for curing, whereinafter curing of the exterior portion of the composite. The cured exterior portion of the composite is operable for reducing the spreading of material(s), if any, migrating from the composite along first and/or second opposing surfaces and/or for providing good adhesion with the first and/or second opposing surfaces that inhibits sliding of the composite along the first and/or second opposing surfaces.

In an exemplary method for reducing the spreading of material(s), if any, migrating from a composite, the method comprises curing an exterior portion of a composite, such that the cured exterior portion of the composite is operable for reducing the spreading of material(s), if any, migrating from the composite along first and/or second opposing surfaces and/or such that the cured exterior portion of the composite is operable for providing good adhesion with the first and/or second opposing surfaces that inhibits sliding of the composite along the first and/or second opposing surfaces.

In exemplary embodiments, the method includes positioning the composite between the first and second opposing surfaces such that only the exterior portion of the composite remains exposed to oxygen for curing as the first and second opposing surfaces inhibit oxygen from reaching an interior portion of the composite.

In exemplary embodiments, the method includes curing only the exterior portion of the composite such that the remaining interior portion of the composite is uncured. In such exemplary embodiments, the method may include curing only the exterior portion of the composite after positioning the composite between the first and second opposing surfaces.

In exemplary embodiments, the method includes exposing only the exterior portion of the composite to oxygen for curing such that only the exterior portion of the composite is cured and the remaining interior portion of the composite is uncured. In such exemplary embodiments, the method may include exposing only the exterior portion of the composite to oxygen for curing after positioning the composite between the first and second opposing surfaces.

In exemplary embodiments, only the exterior portion of the composite is cured such that the remaining interior portion of the composite is uncured. And the cured exterior portion of the composite is disposed generally around the uncured interior portion of the composite. The cured exterior portion is operable for reducing the spreading of material(s), if any, migrating from the uncured interior portion of the composite along the first and/or second opposing surfaces.

In exemplary embodiments, only the exterior portion of the composite is cured such that the remaining interior portion of the composite is uncured. And the cured exterior portion of the composite provides adhesion with the first and/or second opposing surfaces that is better than the adhesion of the uncured interior portion of the composite with the first and/or second opposing surfaces.

In exemplary embodiments, only the exterior portion of the composite is cured such that the remaining interior portion of the composite is uncured. And the cured exterior portion of the composite forms a barrier generally around the uncured interior portion of the composite that inhibits oxygen from reaching the uncured interior portion of the composite.

In exemplary embodiments, the composite includes first and second surfaces disposed against the first and second opposing surfaces, respectively. An outermost perimeter sidewall portion extends along a perimeter of the composite between the first and second surfaces of the composite. The outermost perimeter sidewall portion sidewall defines the exterior portion of the composite. In such exemplary embodiments, the first and second surfaces of the composite may be positioned in contact against the first and second opposing surfaces, respectively, such that the first and second opposing surfaces inhibit oxygen from reaching the first and second surfaces, respectively, of the composite.

In exemplary embodiments, first and second opposing surfaces and the cured exterior portion of the composite inhibits oxygen from reaching an interior portion of the composite.

In exemplary embodiments, the method includes dispensing the composite onto the first and/or second opposing surfaces.

In exemplary embodiments, the composite is a one-part dispensable.

In exemplary embodiments, the composite comprises liquid butadiene and one or more functional fillers within the liquid butadiene. For example, the composite may include about 3 weight percent (wt%) to about 10 wt% of the liquid butadiene, and about 90 wt% to about 97 wt% of the one or more functional fillers. And the one or more functional fillers may comprise one or more of zinc oxide, aluminum oxide, boron nitride, aluminum, silicon carbide, and/or aluminum nitride.

In exemplary embodiments, the composite comprises one or more of thermally-conductive filler(s), electrically-conductive filler(s), electromagnetic wave absorbing filler(s), dielectric absorbing filler(s), and/or filler(s) that has two or more properties of being thermally conductive, electrically conductive, dielectric absorbing, and electromagnetic wave absorbing.

In exemplary embodiments, the composite is useful for the management of heat and/or electromagnetic interference (EMI).

In exemplary embodiments, the composite is a one-part dispensable thermal interface material.

In exemplary embodiments, the composite is a thermal interface material, an EMI absorber, a thermally-conductive absorber, an electrically-conductive elastomer, an electrically-conductive composite, or a combination of two or more thereof.

In exemplary embodiments, the composite has a thermal conductivity within a range from about 3 Watts per meter per Kelvin (W/mK) to about 10 W/mK. For example, the composite may have a thermal conductivity of about 6.4 W/mK.

In exemplary embodiments, the composite has a flow rate of about 60 grams per minute.

In exemplary embodiments, the method includes positioning the composite between first and second components that comprise one or more of: a heat removal/dissipation structure such as a heat sink, a heat spreader, a heat pipe, a vapor chamber, a device exterior case, a device housing, or a device chassis; a heat source of an electronic device, such as an integrated circuit or other component of the electronic device; and/or a board level shield.

In exemplary embodiments, the cured exterior portion of the composite is operable for reducing the spreading of material(s), if any, migrating from the composite along the first and/or second opposing surfaces such that the composite is usable substantially or entirely without material migration along the first and/or second opposing surfaces beyond confines of the composite.

In exemplary embodiments, the cured exterior portion of the composite is operable for reducing the spreading of silicone oil bleed from the composite along the first and/or second opposing surfaces.

In exemplary embodiments, the cured exterior portion of the composite is operable for reducing the spreading of silicone oil bleed from the composite along the first and/or second opposing surfaces such that the composite is usable substantially or entirely without silicone migration beyond confines of the composite.

In exemplary embodiments, the cured exterior portion of the composite is operable for reducing the spreading of non-silicone oil bleed and/or hydrocarbon oil bleed from the composite along the first and/or second opposing surfaces.

In exemplary embodiments, the cured exterior portion of the composite is operable for reducing the spreading of non-silicone oil bleed and/or hydrocarbon oil bleed from the composite along the first and/or second opposing surfaces such that the composite is usable substantially or entirely without non-silicone oil bleed and/or hydrocarbon oil bleed migration beyond confines of the composite.

In exemplary embodiments, the composite is a pad.

In exemplary embodiments, the composite is a thermal phase change material, a thermal putty, a thermal grease, a dispensable thermal interface material (*e.g*., a one-part dispensable thermal interface material, *etc.),* and/or a thermal gap filler pad.

In exemplary embodiments, the cured exterior portion of the composite comprises an integral cured, oxidized, and/or hardened portion of the composite such that the cured exterior portion has a same formulation as a remainder of the composite.

In exemplary embodiments, a composite comprises an uncured interior portion and a cured exterior portion disposed generally around the uncured interior portion of the composite. The cured exterior portion of the composite is operable for at least one or more of: reducing the spreading of material(s), if any, migrating from the uncured interior portion of the composite along a surface; and/or providing adhesion with the surface that inhibits sliding of the composite along the surface and that is better than the adhesion of the uncured interior portion of the composite with the surface; and/or forming a barrier generally around the uncured interior portion of the composite that inhibits oxygen from passing through the barrier to the uncured interior portion of the composite.

In exemplary embodiments, the composite may be a one-part dispensable comprising liquid butadiene and one or more functional fillers within the liquid butadiene. In such exemplary embodiments, the composite may include about 3 weight percent (wt%) to about 10 wt% of liquid butadiene and about 90 wt% to about 97 wt% of one or more functional fillers within the liquid butadiene. The functional filler may comprise one or more of zinc oxide, aluminum oxide, boron nitride, aluminum, silicon carbide, and/or aluminum nitride. The composite may have a thermal conductivity within a range from about 3 Watts per meter per Kelvin (W/mK) to about 10 W/mK. The cured exterior portion of the composite comprises an integral cured, oxidized, and/or hardened portion of the composite such that the cured exterior portion has a same formulation as a remainder of the composite. The composite may include first and second surfaces and an outermost perimeter sidewall portion extending along a perimeter of the composite between the first and second surfaces of the composite. The outermost perimeter sidewall portion may define the cured exterior portion of the composite.

In exemplary embodiments, the cured exterior portion of the composite comprises an integral cured, oxidized, and/or hardened portion of the composite such that the cured exterior portion has a same formulation as a remainder of the composite. And the cured exterior portion of the composite is operable for each of: reducing the spreading of material(s), if any, migrating from the uncured interior portion of the composite along the surface; providing adhesion with the surface that inhibits sliding of the composite along the surface and that is better than the adhesion of the uncured interior portion of the composite with the surface; and forming the barrier generally around the uncured interior portion of the composite that inhibits oxygen from passing through the barrier to the uncured interior portion of the composite.

In exemplary embodiments, an assembly or electronic device comprises first and second opposing surfaces. A composite (e.g., a one-part dispensable, etc.) as disclosed herein is between the first and second opposing surfaces. The first and second opposing surfaces of the assembly or electronic device are defined by one or more of a heat sink, a heat spreader, a heat pipe, a vapor chamber, a device exterior case, a device housing, a device chassis, or other heat removal/dissipation structure; an integrated circuit or other heat source; and/or a board level shield.

In exemplary embodiments, a one-part dispensable comprises liquid butadiene and one or more functional fillers within the liquid butadiene. The one-part dispensable includes an uncured interior portion and a cured exterior portion disposed generally around the uncured interior portion of the one-part dispensable. The cured exterior portion of the one-part dispensable is operable for at least one or more of: reducing the spreading of material(s), if any, migrating from the uncured interior portion of the one-part dispensable along a surface; and/or providing adhesion with the surface that inhibits sliding of the one-part dispensable along the surface and that is better than the adhesion of the uncured interior portion of the one-part dispensable with the surface; and/or forming a barrier generally around the uncured interior portion of the one-part dispensable that inhibits oxygen from passing through the barrier to the uncured interior portion of the one-part dispensable. In such exemplary embodiments, the one-part dispensable may include about 3 weight percent (wt%) to about 10 wt% of liquid butadiene and about 90 wt% to about 97 wt% of one or more functional fillers. And the functional filler may comprise one or more of zinc oxide, aluminum oxide, boron nitride, aluminum, silicon carbide, and/or aluminum nitride. The cured exterior portion of the one-part dispensable comprises an integral cured, oxidized, and/or hardened portion of the one-part dispensable such that the cured exterior portion has a same formulation as a remainder of the one-part dispensable. The one-part dispensable may include first and second surfaces and an outermost perimeter sidewall portion extending along a perimeter of the one-part dispensable between the first and second surfaces of the one-part dispensable. The outermost perimeter sidewall portion may define the cured exterior portion of the one-part dispensable.

In exemplary embodiments, the cured exterior portion of the one-part dispensable comprises an integral cured, oxidized, and/or hardened portion of the one-part dispensable such that the cured exterior portion has a same formulation as a remainder of the one-part dispensable. And the cured exterior portion of the one-part dispensable is operable for each of: reducing the spreading of material(s), if any, migrating from the uncured interior portion of the one-part dispensable along the surface; providing adhesion with the surface that inhibits sliding of the one-part dispensable along the surface and that is better than the adhesion of the uncured interior portion of the one-part dispensable with the surface; and forming the barrier generally around the uncured interior portion of the one-part dispensable that inhibits oxygen from passing through the barrier to the uncured interior portion of the one-part dispensable.

In an exemplary embodiments, an electronic device includes a heat source and a thermally-conductive composite *(e.g.,* one-part dispensable thermal interface material, *etc.).* The thennally-conductive composite is positioned relative to the heat source for establishing at least a portion of a thermally-conductive heat path from the heat source through the composite. The thermally-conductive composite includes an exterior portion *(e.g.,* outermost perimeter sidewall portion, *etc.)* that is cured, oxidized, and/or otherwise hardened such that the exterior portion is operable for preventing or inhibiting further spreading of material(s), if any, migrating (*e.g*., oil bleeding, *etc.)* from the thermally-conductive composite along the heat source. Accordingly, the exterior portion of the thermally-conductive composite that is cured, oxidized, and/or otherwise hardened enables the thermally-conductive composite to have a low level of bleeding. The exterior portion of the thermally-conductive composite that is cured, oxidized, and/or otherwise hardened also provides good adhesion with the heat source. The good adhesion provided between the exterior portion of the thermally-conductive composite and the heat source prevents or inhibits sliding of the thermally-conductive composite along the heat source, such as during thermal cycling and/or vibration, *etc.* The cured, oxidized, and/or hardened exterior portion of the thermally-conductive composite may provide good adhesion with the heat source that is better or stronger than the adhesion between the heat source and the interior portion of the thermally-conductive composite (e.g., a naturally or inherently tacky material, *etc*.*)* that is not cured, oxidized, and/or otherwise hardened. In such exemplary embodiments, the thermally-conductive composite may also be configured to be EMI absorbing and/or electrically conductive, such that the composite is also operable for mitigating and/or managing EMI within the electronic device.

In an exemplary embodiment, an electronic device includes a heat source, a heat removal/dissipation structure, and a thermally-conductive composite (*e.g*., one-part dispensable thermal interface material, *etc.).* The thermally-conductive composite is positioned relative to the heat source and the heat removal/dissipation structure for establishing at least a portion of a thermally-conductive heat path between the heat source and the heat removal/dissipation structure. The thermally-conductive composite includes an exterior portion (*e.g*., outermost perimeter sidewall portion, *etc.)* that is cured, oxidized, and/or otherwise hardened such that the exterior portion is operable for preventing or inhibiting further spreading of material(s), if any, migrating (*e.g*., oil bleeding, *etc.)* from the thermally-conductive composite along the heat source and the heat removal/dissipation structure. Accordingly, the exterior portion of the thermally-conductive composite that is cured, oxidized, and/or otherwise hardened enables the thermally-conductive composite to have a low level of bleeding. The exterior portion of the thermally-conductive composite that is cured, oxidized, and/or otherwise hardened also provides good adhesion with the heat source and the heat removal/dissipation structure. The good adhesion provided between the exterior portion of the thermally-conductive composite and the heat source and the heat removal/dissipation structure prevents or inhibits sliding of the thermally-conductive composite along the heat source and the heat removal/dissipation structure, such as during thermal cycling and/or vibration, *etc.* The cured, oxidized, and/or hardened exterior portion of the thermally-conductive composite may provide good adhesion that is better or stronger than the adhesion between the heat source and heat removal/dissipation structure and the interior portion of the thermally-conductive composite (*e.g*., a naturally or inherently tacky material, *etc*.) that is not cured, oxidized, and/or otherwise hardened. In such exemplary embodiments, the thermally-conductive composite may also be configured to be EMI absorbing and/or electrically conductive, such that the composite is also operable for mitigating and/or managing EMI within the electronic device.

In an exemplary embodiment, an electronic device includes a heat source, a board level shield, and a thermally-conductive composite (*e.g*., one-part dispensable thermal interface material, *etc.).* The thermally-conductive composite is positioned relative to the heat source and the board level shield for establishing at least a portion of a thermally-conductive heat path between the heat source and the board level shield. The thermally-conductive composite includes an exterior portion (*e.g*., outermost perimeter sidewall portion, *etc*.) that is cured, oxidized, and/or otherwise hardened such that the exterior portion is operable for preventing or inhibiting further spreading of material(s), if any, migrating (*e.g.*, oil bleeding, *etc*.) from the thermally-conductive composite along the heat source and the board level shield structure. Accordingly, the exterior portion of the thermally-conductive composite that is cured, oxidized, and/or otherwise hardened enables the thermally-conductive composite to have a low level of bleeding. The exterior portion of the thermally-conductive composite that is cured, oxidized, and/or otherwise hardened also provides good adhesion with the heat source and the board level shield structure. The good adhesion provided between the exterior portion of the thermally-conductive composite and the heat source and the board level shield structure prevents or inhibits sliding of the thermally-conductive composite along the heat source and the board level shield structure, such as during thermal cycling and/or vibration, *etc.* The cured, oxidized, and/or hardened exterior portion of the thermally-conductive composite may provide good adhesion that is better or stronger than the adhesion between the heat source and board level shield structure and the interior portion of the thermally-conductive composite (*e.g.,* a naturally or inherently tacky material, *etc.)* that is not cured, oxidized, and/or otherwise hardened. In such exemplary embodiments, the thermally-conductive composite may also be configured to be EMI absorbing and/or electrically conductive, such that the composite is also operable for mitigating and/or managing EMI within the electronic device.

In an exemplary embodiment, an electronic device includes a heat source, a board level shield, a heat removal/dissipation structure, and first and second thermally-conductive composites (*e.g*., one-part dispensable thermal interface materials, *etc.* The first thermally-conductive composite is positioned relative to the heat source and the board level shield for establishing at least a portion of a first thermally-conductive heat path between the heat source and the board level shield. The second thermally-conductive composite is positioned relative to the board level shield and the heat removal/dissipation structure for establishing at least a portion of a second thermally-conductive heat path between the board level shield and the heat removal/dissipation structure. The first and second thermally-conductive composites each includes an exterior portion (*e.g*., outermost perimeter sidewall portion, *etc.)* that is cured, oxidized, and/or otherwise hardened such that the exterior portion is operable for preventing or inhibiting further spreading of material(s), if any, migrating (*e.g*., oil bleeding, *etc.)* from the first or second thermally-conductive composites. The exterior portions of the first and second thermally-conductive composites that are cured, oxidized, and/or otherwise hardened also provide good adhesion. In such exemplary embodiments, the first and/or second thermally-conductive composites may also be configured to be EMI absorbing and/or electrically conductive, such that the first and/or second thermally conductive composites are also operable for mitigating and/or managing EMI within the electronic device.

In an exemplary embodiment, an electronic device includes an integrated circuit, a board level shield, a heat sink, and first and second thermally-conductive composites (e.g., one-part dispensable thermal interface materials, *etc.).* The first thermally-conductive composite is positioned relative to the integrated circuit and the board level shield for establishing at least a portion of a first thermally-conductive heat path between the integrated circuit and the board level shield. The second thermally-conductive composite is positioned relative to the board level shield and the heat sink for establishing at least a portion of a second thermally-conductive heat path between the board level shield and the heat sink. The first and second thermally-conductive composites each includes an exterior portion (e.g., outermost perimeter sidewall portion, *etc.)* that is cured, oxidized, and/or otherwise hardened such that the exterior portion is operable for preventing or inhibiting further spreading of material(s), if any, migrating (e.g., oil bleeding, *etc.)* from the first or second thermally-conductive composites. The exterior portions of the first and second thermally-conductive composites that are cured, oxidized, and/or otherwise hardened also provide good adhesion. In such exemplary embodiments, the first and/or second thermally-conductive composites may also be configured to be EMI absorbing and/or electrically conductive, such that the first and/or second thermally conductive composites are also operable for mitigating and/or managing EMI within the electronic device. In such exemplary embodiments, the first and/or second thermally-conductive composites may be configured to be EMI absorbing and/or electrically conductive, such that the first and/or second composites are also operable for mitigating and/or managing EMI within the electronic device.

In exemplary embodiments, the one-part dispensable is a thermal management and/or EMI mitigation material, a thermal interface material (TIM), an EMI absorber, an electrically-conductive composite, a polymer-inorganic composite material used for other purposes, combinations thereof, *etc.* In exemplary embodiments, the one-part dispensable is a one-part dispensable thermal management material or thermal interface material (TIM). In other exemplary embodiments, the one-part dispensable is a one-part dispensable EMI mitigation material (e.g., an EMI absorber, *etc.).* In further exemplary embodiments, the one-part dispensable is usable as both a thermal management material and EMI mitigation material *(e.g.,* a thermally-conductive EMI absorber, *etc.).* Accordingly, aspects of the present disclosure should not be limited to one-part dispensables configured to be usable for a single particular purpose, *etc.*

In exemplary embodiments, the one-part dispensable has a relatively high thermal conductivity (e.g., 1 W/mK (watts per meter per Kelvin), 2 W/mK, 3 W/mK, 4 W/mK, 5 W/mK, 6 W/mK, 7 W/mK, 8 W/mK, 9 W/mK, 10 W/mK, greater than 10 W/mK, *etc*.) depending on the particular materials used to make the one-part dispensable and loading percentage of the thermally conductive filler, if any. These thermal conductivities are only examples as other embodiments may include a one-part dispensable with a thermal conductivity higher than 10 W/mK, less than 1 W/mK, or a value within a range from 1 W/mK to 10 W/mK.

Example embodiments of the one-part dispensables disclosed herein may be used for a wide range of heat sources, electronic devices, and/or heat removal/dissipation structures or components (*e.g.,* a heat spreader, a heat sink, a heat pipe, a vapor chamber, a device exterior case, housing, or chassis, *etc.).* For example, a heat source may comprise one or more heat generating components or devices, such as a high-power integrated circuit (IC), optical transceiver, 5G infrastructure devices (e.g., base stations, small cells, smart poles, *etc*.), solid-state drive (SSD), memory in video cards, set top boxes, televisions, gaming systems, automotive electronics used for autonomous driving (ADAS) (e.g., radars, multi domain controllers, cameras, *etc.),* a CPU, die within underfill, semiconductor device, flip chip device, graphics processing unit (GPU), digital signal processor (DSP), multiprocessor system, integrated circuit (IC), multi-core processor, *etc.*)*.* Generally, a heat source may comprise any component or device that has a higher temperature than the one-part dispensable (e.g., thermal management and/or EMI mitigation material, *etc.)* or otherwise provides or transfers heat to the one-part dispensable regardless of whether the heat is generated by the heat source or merely transferred through or via the heat source. Accordingly, aspects of the present disclosure should not be limited to use with any single type of heat source, electronic device, heat removal/dissipation structure, *etc.*

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e*., the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (e.g., "between" versus "directly between," "adjacent" versus "directly adjacent," *etc*.). As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method for reducing the spreading of material(s), if any, migrating from a composite, the method comprising curing an exterior portion of the composite such that the cured exterior portion of the composite is operable for:
reducing the spreading of material(s), if any, migrating from the composite along a surface; and/or providing good adhesion with the surface that inhibits sliding of the composite along the surface.

2. The method of claim 1, wherein the method includes curing only the exterior portion of the composite such that an interior portion of the composite remains uncured and the cured exterior portion of the composite is disposed generally around the uncured interior portion of the composite, whereby the cured exterior portion of the composite is operable for reducing the spreading of material(s), if any, migrating from the uncured interior portion of the composite along the surface.

3. The method of claim 1, wherein the method includes curing only the exterior portion of the composite such that an interior portion of the composite remains uncured and the cured exterior portion of the composite provides adhesion with the surface that is better than the adhesion of the uncured interior portion of the composite with the surface.

4. The method of claim 1, wherein the method includes curing only the exterior portion of the composite such that an interior portion of the composite remains uncured and the cured exterior portion of the composite forms a barrier generally around the uncured interior portion of the composite that inhibits oxygen from passing through the barrier to the uncured interior portion of the composite.

5. The method of claim 1, wherein the method includes curing only the exterior portion of the composite such that an interior portion of the composite remains uncured and such that:
the cured exterior portion of the composite is disposed generally around the uncured interior portion of the composite, whereby the cured exterior portion of the composite is operable for reducing the spreading of material(s), if any, migrating from the uncured interior portion of the composite along the surface; and
the cured exterior portion of the composite provides adhesion with the surface that is better than the adhesion of the uncured interior portion of the composite with the surface; and
the cured exterior portion of the composite forms a barrier generally around the uncured interior portion of the composite that inhibits oxygen from passing through the barrier to the uncured interior portion of the composite.

6. The method of any one of the preceding claims, wherein the method includes positioning the composite between first and second opposing surfaces such that only the exterior portion of the composite remains exposed to oxygen during the curing of the exterior portion of the composite as the first and second opposing surfaces inhibit oxygen from reaching an interior portion of the composite, whereby only the exterior portion of the composite is cured and the interior portion of the composite remains uncured.

7. The method of claim 6, wherein:
the composite is a dispensable; and
positioning the composite between the first and second opposing surfaces comprises dispensing the dispensable onto either or both of the first and second opposing surfaces.

8. The method of any one of the preceding claims, wherein the method includes exposing only the exterior portion of the composite to oxygen during the curing of the exterior portion of the composite such that only the exterior portion of the composite is cured and an interior portion of the composite remains uncured.

9. The method of any one of the preceding claims, wherein the method includes curing only the exterior portion of the composite such that an interior portion of the composite remains uncured.

10. The method of any one of the preceding claims, wherein:
the composite includes first and second surfaces and an outermost perimeter sidewall portion extending along a perimeter of the composite between the first and second surfaces of the composite, the outermost perimeter sidewall portion defining the exterior portion of the composite; and
the method includes positioning the first and second surfaces of the composite against first and second opposing surfaces, respectively, such that the first and second opposing surfaces inhibit oxygen from reaching the first and second surfaces, respectively, of the composite during the curing of the exterior portion of the composite.

11. The method of any one of the preceding claims, wherein:
the composite is a one-part dispensable; and/or
the composite comprises liquid butadiene and one or more functional fillers within the liquid butadiene.

12. The method of any one of the preceding claims, wherein:
the composite includes about 3 weight percent (wt%) to about 10 wt% of liquid butadiene and about 90 wt% to about 97 wt% of one or more functional fillers within the liquid butadiene; and/or
the composite includes functional filler comprising one or more of zinc oxide, aluminum oxide, boron nitride, aluminum, silicon carbide, and/or aluminum nitride such that the composite has a thermal conductivity within a range from about 3 Watts per meter per Kelvin (W/mK) to about 10 W/mK.

13. The method of any one of the preceding claims, wherein:
the cured exterior portion of the composite comprises an integral cured, oxidized, and/or hardened portion of the composite such that the cured exterior portion has a same formulation as a remainder of the composite; and/or
the composite is a thermal phase change material, a thermal putty, a thermal grease, a dispensable thermal interface material, and/or a thermal gap filler pad.

14. A composite comprising an uncured interior portion and a cured exterior portion disposed generally around the uncured interior portion of the composite, whereby the cured exterior portion of the composite is operable for at least one or more of:
reducing the spreading of material(s), if any, migrating from the uncured interior portion of the composite along a surface;
providing adhesion with the surface that inhibits sliding of the composite along the surface and that is better than the adhesion of the uncured interior portion of the composite with the surface; and
forming a barrier generally around the uncured interior portion of the composite that inhibits oxygen from passing through the barrier to the uncured interior portion of the composite.

15. The composite of claim 14, wherein:
the composite is a one-part dispensable; and/or
the composite comprises liquid butadiene and one or more functional fillers within the liquid butadiene; and/or
the composite includes first and second surfaces and an outermost perimeter sidewall portion extending along a perimeter of the composite between the first and second surfaces of the composite, the outermost perimeter sidewall portion defining the cured exterior portion of the composite; and/or
the cured exterior portion of the composite comprises an integral cured, oxidized, and/or hardened portion of the composite such that the cured exterior portion has a same formulation as a remainder of the composite.
